# EUROPEAN PATENT APPLICATION

(11) **EP 1 715 508 A2**
(43) Date of publication of application: **25.10.2006**
(21) Application number: 06007328.5
(22) Date of filing: 06.04.2006
(51) Int. Cl.: H01L 21/00

(54) **Single thin plate storage container**

(30) Priority: 21.04.2005 JP 2005123993
(71) Applicant: Miraial Co., Ltd., Tokyo (JP)
(72) Inventor: Nishizaka, Koichi, Shisui-machi Kikuchi-shi Kumamoto-ken (JP); Emura, Yoichi, Shisui-machi Kikuchi-shi Kumamoto-ken (JP); Obayashi, Tadahiro, Shisui-machi Kikuchi-shi Kumamoto-ken (JP)
(74) Representative: Grünecker, Kinkeldey, Stockmair & Schwanhäusser Anwaltssozietät

(57) **Abstract**

A single thin plate storage container is provided so that a housed semiconductor wafer is capable of easy insertion and removal. The single thin plate storage container includes a container body which houses a single semiconductor wafer therein and a lid unit attached to the container body. The container body includes a bottom plate on which the semiconductor wafer is placed and a peripheral wall portion formed around the bottom plate, and the bottom plate is formed by protruding up to a position higher than the peripheral wall portion. The bottom plate of the container body is provided with a plurality of thin plate supporting convex strips for supporting the semiconductor wafer in a state where a space is provided between the semiconductor wafer and the bottom plate. The inner side surface of the top plate of the lid unit is provided with a plurality of retainers which support a peripheral portion of the semiconductor wafer placed on the bottom plate of the container body.

## Description

### BACKGROUND OF THE INVENTION

The present invention relates to a single thin plate storage container for housing a thin plate such as a semiconductor wafer, a storage disk, or a liquid crystal glass substrate so as to be used in a storing, transporting, or manufacturing process or the like.

A single thin plate storage container for housing a thin plate such as a semiconductor wafer so as to be stored or transported is generally known. As an example of the single thin plate storage container, Japanese Patent Application Laid-Open No. 5-508747 describes a single wafer robotic package. The robotic package has a compartment for housing a wafer. The wafer is inserted into the compartment to be stored, transported or the like.

There is another type of single thin plate storage container including a shallow plate-like container body and a lid unit.

However, in the case of the above-mentioned robotic package, it is not easy to insert or remove a wafer into or out of the compartment. This results in decreased operational efficiency.

On the other hand, the single thin plate storage container constituted by a shallow plate-like container body and a lid unit allows for a smooth insertion or removal of a wafer rather than the robotic package. Also in this case, the wafer needs to be removed from above. Since the plate-like container body has a wall portion of the container body around a housed wafer, vacuum tweezers of a transporting apparatus cannot be laterally inserted. Therefore, the wafer needs to be removed from above. This results in decreased operational efficiency.

In addition, when a wafer is increased in size, it is not easy to support only a peripheral portion of the wafer and lift the wafer upward due to a problem of strength. This also results in decreased operational efficiency.

### SUMMARY OF THE INVENTION

In view of the foregoing circumstances, it is an object of the present invention to provide a single thin plate storage container capable of easy insertion and removal of a wafer to be housed.

According to one aspect of the invention for achieving the above object, there is provided a container body which houses a single thin plate therein and a lid unit attached to the container body, wherein the container body includes a bottom plate on which the thin plate is placed and a peripheral wall portion formed around the bottom plate, the bottom plate is formed by protruding up to a position higher than the peripheral wall portion, and the lid unit includes a top plate which covers, from a upper side, the thin plate placed on the bottom plate of the container body and a peripheral wall portion formed around the top plate, the peripheral wall portion forming a space in which houses the thin plate.

The bottom plate is formed by protruding up to a position higher than the peripheral wall portion. Therefore, there is no obstacle around the thin plate placed on the base plate. As a result, the thin plate can be lifted by laterally inserting vacuum tweezers of a transporting apparatus under the thin plate.

The bottom plate portion of the container body preferably includes a plurality of thin plate supporting convex strips for supporting the thin plate in a state where a space is provided between the thin plate and the bottom plate.

This configuration allows for inserting the vacuum tweezers of the transporting apparatus into the space provided between the thin plate and the bottom plate to lift the thin plate.

Therefore, in the single thin plate storage container of the present invention, a large-sized thin plate also can easily be inserted or removed into or out of the single thin plate storage container and securely be supported.

### BRIEF DESCRIPTION OF THE DRAWINGS

Fig. 1 is a sectional perspective view showing a single thin plate storage container according to an embodiment of the present invention;
Fig. 2 is a perspective view showing, from a hook side, a single thin plate storage container according to an embodiment of the present invention;
Fig. 3 is a perspective view showing, from a hinge side, a single thin plate storage container according to an embodiment of the present invention;
Fig. 4 is a perspective view showing a container body of a single thin plate storage container according to an embodiment of the present invention;
Fig. 5 a front view showing a main part of a container body of a single thin plate storage container according to an embodiment of the present invention;
Fig. 6 is a perspective view showing, from a back side, a container body of a single thin plate storage container according to an embodiment of the present invention;
Fig. 7 is a perspective view showing a state in which a semiconductor wafer is placed on a container body of a single thin plate storage container according to an embodiment of the present invention;
Fig. 8 is a sectional perspective view showing a state in which a semiconductor wafer is placed on a container body of a single thin plate storage container according to an embodiment of the present invention;
Fig. 9 is an enlarged perspective view showing a main part of a container body of a single thin plate storage container according to an embodiment of the present invention;

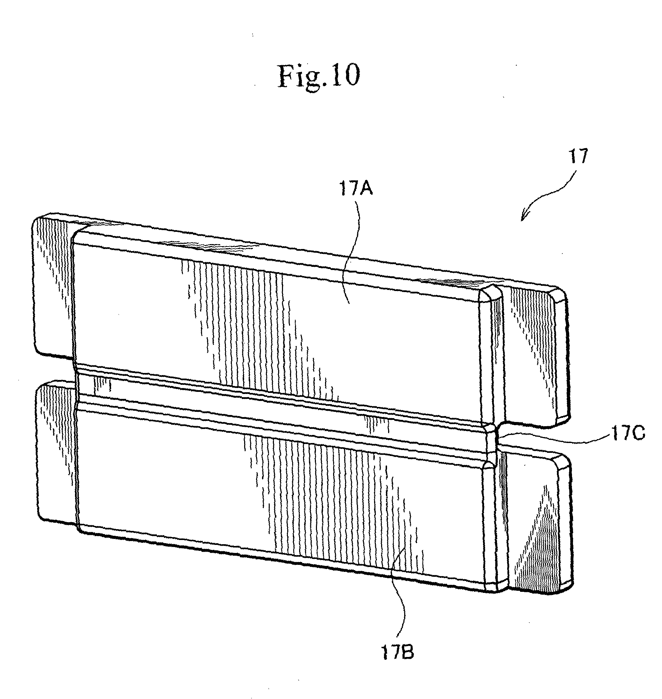

Fig. 10 is a perspective view showing, from a front side, a hinge of a single thin plate storage container according to an embodiment of the present invention;

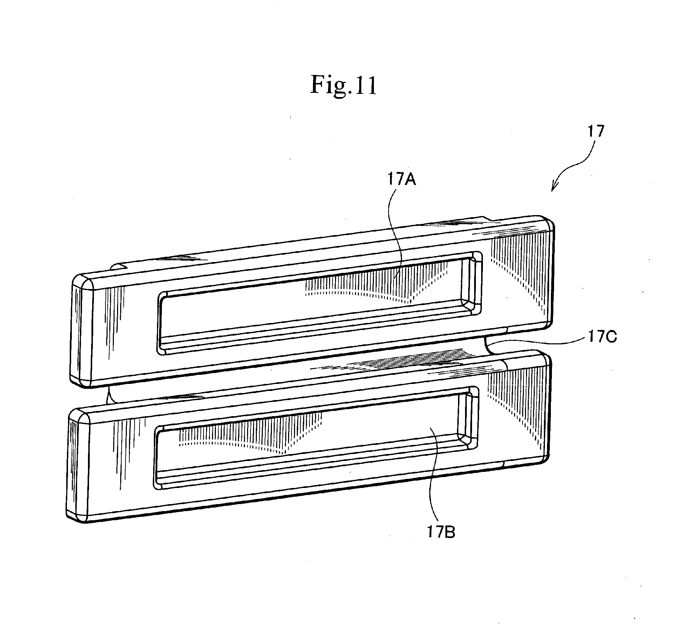

Fig. 11 is a perspective view showing, from a back side, a hinge of a single thin plate storage container according to an embodiment of the present invention;
Fig. 12 is a perspective view showing, from a front side, a hook of a single thin plate storage container according to an embodiment of the present invention;
Fig. 13 is a perspective view showing, from a back side, a hook of a single thin plate storage container according to an embodiment of the present invention;
Fig. 14 is a perspective view showing, from a top side, a lid unit of a single thin plate storage container according to an embodiment of the present invention;
Fig. 15 is a perspective view showing, from a bottom side, a lid unit of a single thin plate storage container according to an embodiment of the present invention;
Fig. 16 is a perspective view showing, from a top side, a retainer of a single thin plate storage container according to an embodiment of the present invention; and
Fig. 17 is a perspective view showing, from a bottom side, a retainer of a single thin plate storage container according to an embodiment of the present invention.

### DESCRIPTION OF THE PREFERRED EMBODIMENTS

An embodiment of the present invention will be described hereinafter with reference to the accompanying drawings. A single thin plate storage container according to the invention is a container for housing, storing and transporting a thin plate such as a large diameter semiconductor wafer and the like.

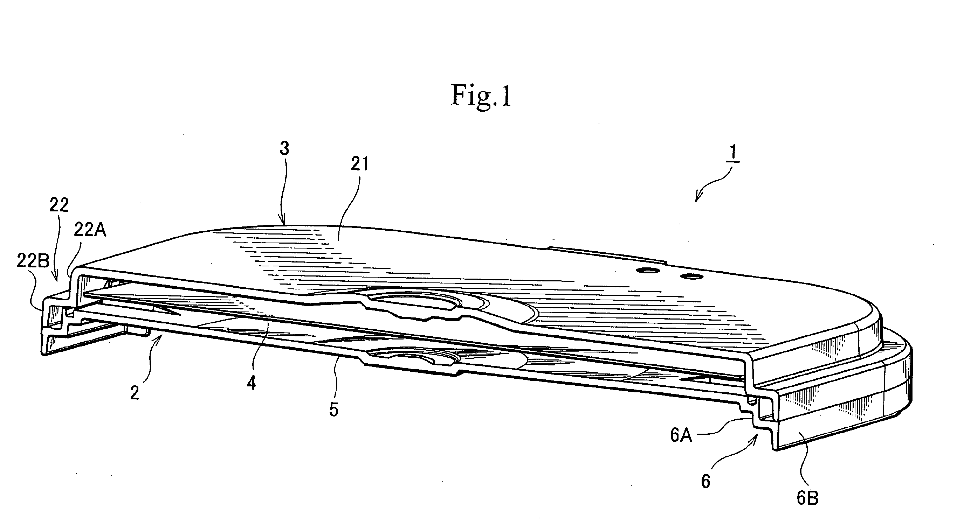

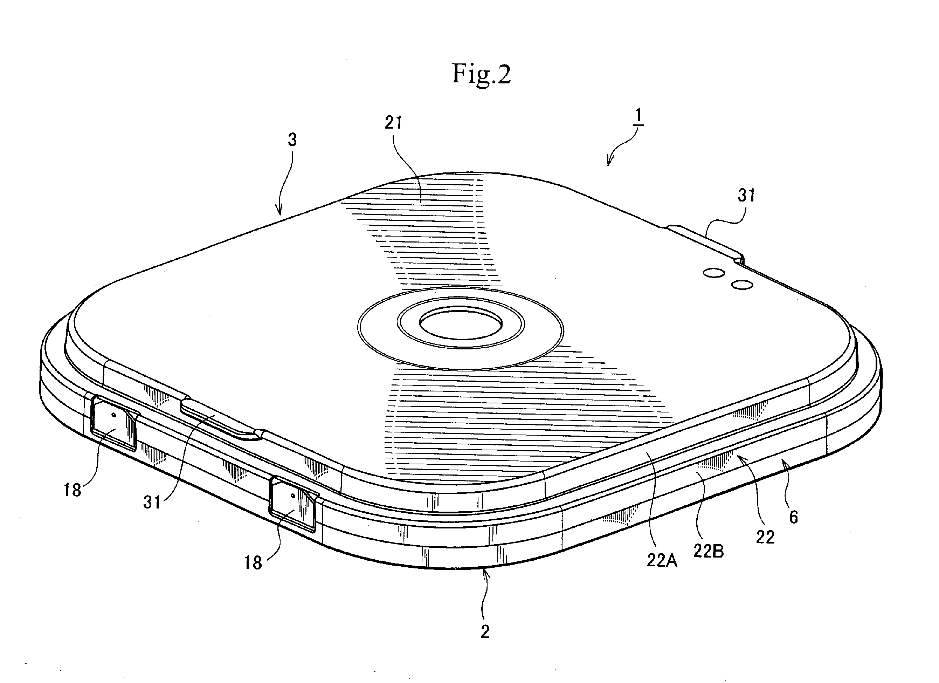

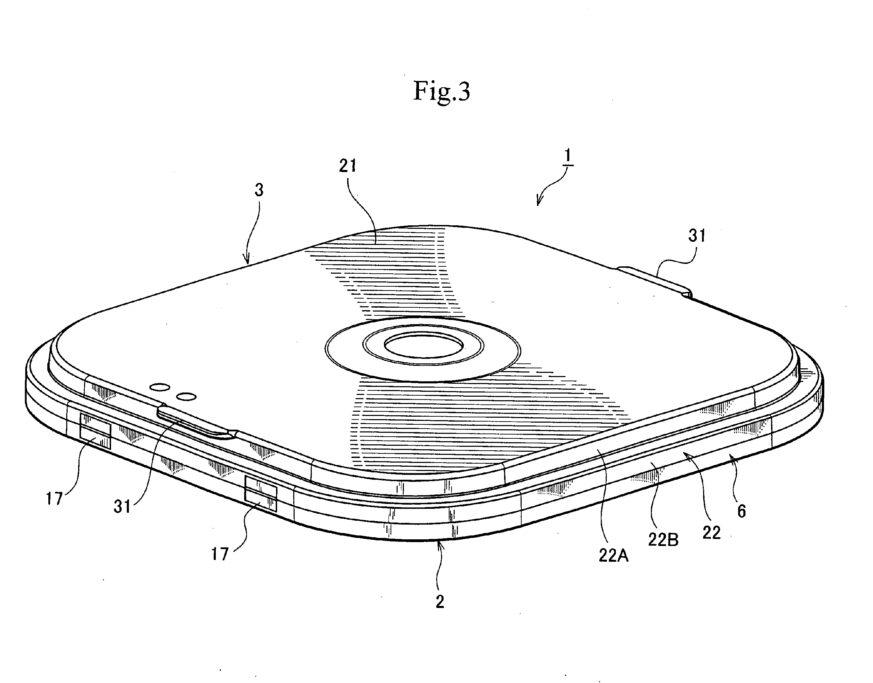

As shown in Figs 1 to 3, a single thin plate storage container 1, manly including a container body 2 and a lid unit 3, is formed into a rectangular shape rounded at each corner. The container body 2 and the lid unit 3 are formed of a transparent high polymer material having antistatic property. The container body 2 and the lid unit 3 are imparted with antistatic property, which prevents adsorption of dust and the like. Further, the container body 2 and the lid unit 3 are formed of a transparent high polymer material, which allows for visually determining the inside condition. Unless both of the container body 2 and the lid unit 3 are formed of an antistatic high polymer material, only one of the container body 2 and the lid unit 3 can be formed of an antistatic high polymer material. Alternatively, unless both of the container body 2 and the lid unit 3 are formed of transparent high polymer material, only the lid unit 3 can be formed of transparent high polymer material. When at least the lid unit 3 is formed of transparent high polymer material, it is possible to visually determine the inside condition.

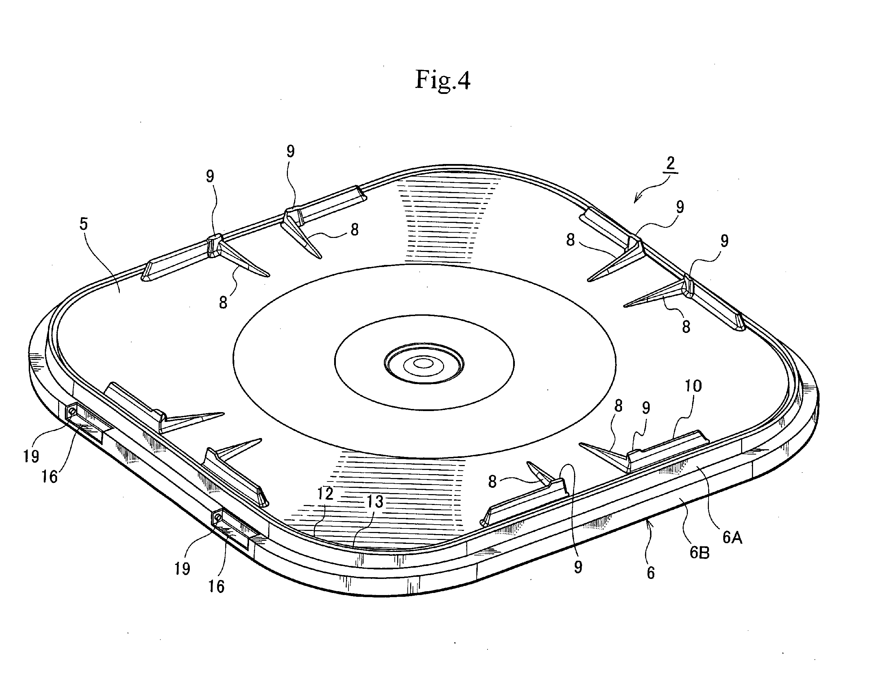

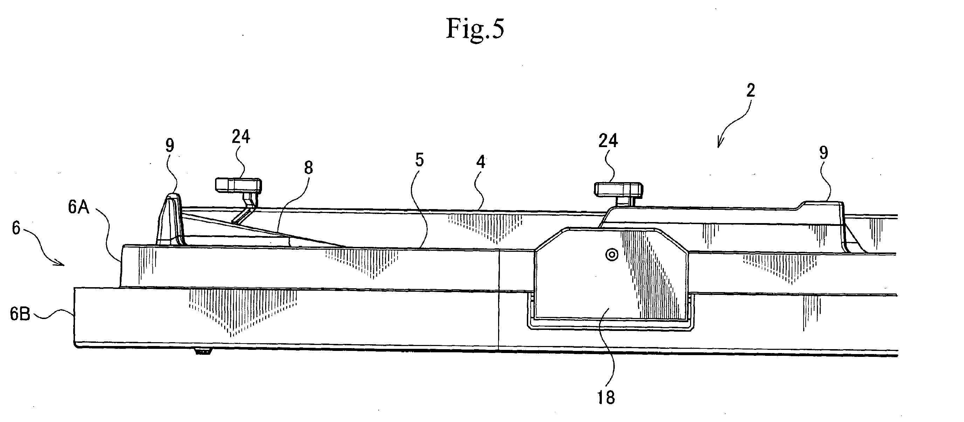

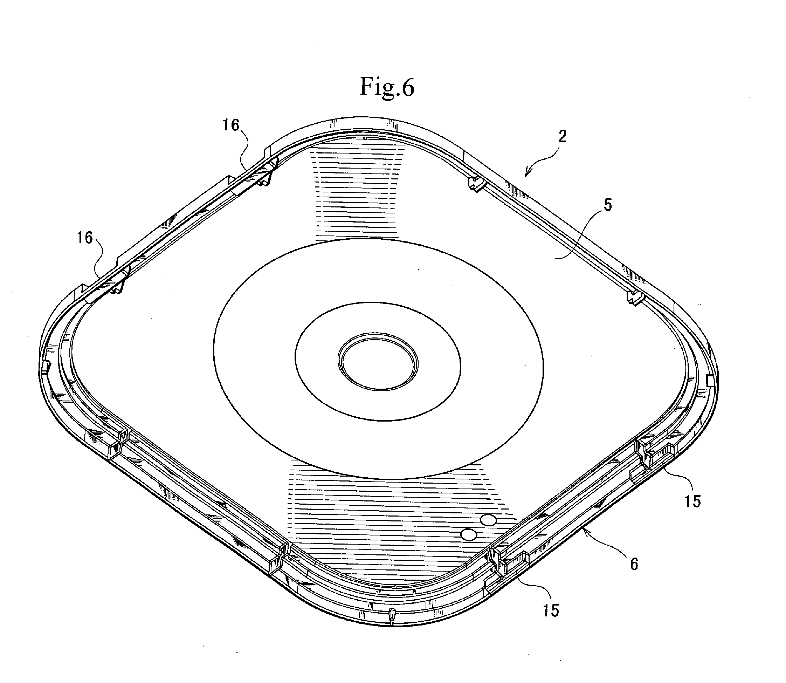

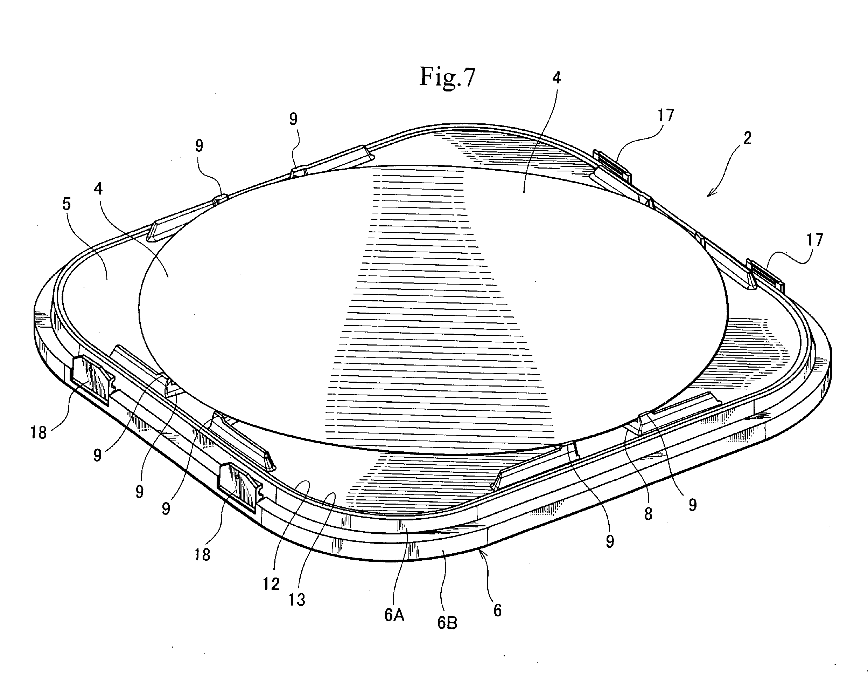

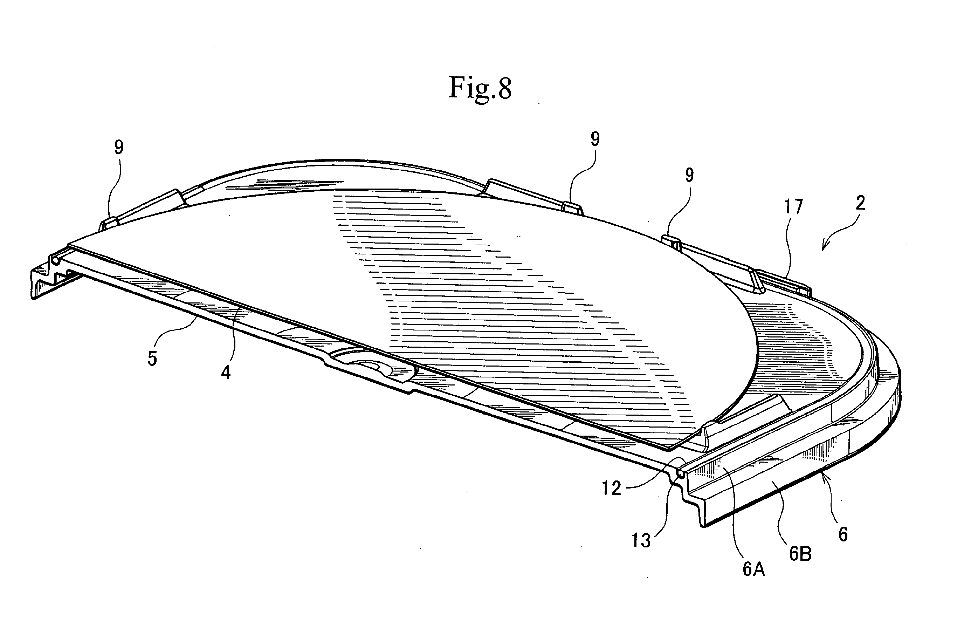

The container body 2 is a member for housing a single semiconductor wafer 4 as a thin plate. As shown in Figs 4 to 9, the container body 2 includes a bottom plate 5 on which the semiconductor wafer 4 is placed and a peripheral wall portion 6 formed around the bottom plate 5.

The bottom plate 5 supports the semiconductor wafer 4 which is housed. The bottom plate 5 is formed by protruding up to a position higher than the peripheral wall portion 6. The is because, when the semiconductor wafer 4 is placed on the bottom plate 5 and when the semiconductor wafer 4 placed on the bottom plate 5 is removed, the peripheral wall portion 6 is not obstructed. That is, after the semiconductor wafer 4 supported by vacuum tweezers (not shown) and the like of a transporting apparatus is placed on the bottom plate 5, when the vacuum tweezers and the like are laterally removed from between the semiconductor wafer 4 and the bottom plate 5 and the semiconductor wafer 4 placed on the bottom plate 5 is lifted by inserting the vacuum tweezers and the like from lateral direction to the lower side of the semiconductor wafer 4, the peripheral wall portion 6 is not obstructed.

The bottom plate 5 has thin plate supporting convex strips 8 and locking pieces 9 on the upper surface.

The thin plate supporting convex strips 8 support the semiconductor wafer 4 in a state where a space is provided between the semiconductor wafer 4 and the bottom plate 5. A plurality of thin plate supporting convex strips 8 are provided at the peripheral portion of the bottom plate 5. In this embodiment, eight thin plate supporting convex strips 8 are provided at the peripheral portion of the bottom plate 5. The respective thin plate supporting convex strip 8 are formed by radially extending from the peripheral portion of the bottom plate 5 toward a center. The thin plate supporting convex strips 8 are formed in a wedge shape in such a manner as to be narrower from the peripheral portion of the bottom plate 5 toward the center. Further, a sectional shape in a circumferential direction of the thin plate supporting convex strips 8 is formed in a substantially triangular shape in such a manner as to be narrower toward a contact portion with the semiconductor wafer 4. Substantially forming the thin plate supporting convex strips 8 in sectional shape comes into point contact with the peripheral portion of the semiconductor wafer 4. Alternatively, the contact portion may be come into line contact or surface contact instead of point contact. Considering a shape of the thin plate supporting convex strips 8, a dimension of the semiconductor wafer 4, and a required strength and the like, the thin plate supporting convex strips 8 are formed so as to contact with a minimal possible area.

Therefore, the thin plate supporting convex strips 8 uniformize a force acting on the semiconductor wafer 4 and applies a uniform holding force to the semiconductor wafer 4. This arises from the following reason. In cooperation with retainers 24, the thin plate supporting convex strips 8 have a function for disposing the semiconductor wafer 4 at the center of the bottom plate 5. That is, since the thin plate supporting convex strips 8 are formed in a wedge shape to be inclined, the peripheral portion of the semiconductor wafer 4 is placed on the thin plate supporting convex strips 8, which applies a force acting toward the center of the bottom plate 5 to the semiconductor wafer 4. Further, the retainers 24 also provide a force acting toward the center of the bottom plate 5 to the semiconductor wafer 4. Although the retainers 24 press the peripheral portion of the semiconductor wafer 4 downward and radially inward, the downward pressing force acts on the peripheral portion of the semiconductor wafer 4 placed on a wedge-shaped inclined portion of the thin plate supporting convex strips 8, causing a force for pressing the semiconductor wafer 4 toward the center of the bottom plate 5. Further, the force decreases as the semiconductor wafer 4 moves away from the retainers 24 and increases as the semiconductor wafer 4 approaches the retainers 24. The same applies to the retainers 24 whose force pushing the semiconductor wafer 4 radially inward. On the other hand, the thin plate supporting convex strips 8 and the semiconductor wafer 4 have a narrow contact area and a low frictional resistance, so that the semiconductor wafer 4 can be easily moved by the pressing force. Therefore, the semiconductor wafer 4 moves in a position at which a pressing force is balanced by the plurality of retainers 24 and thin plate supporting convex strips 8 disposed in the periphery thereof.

As a result, a radially inward pressing force which the retainers 24 and the thin plate supporting convex strips 8 possess and a radially inward pressing force generated by cooperating the retainers 24 with the thin plate supporting convex strips 8 are balanced at the place where the semiconductor wafer 4 is moved at the center of the bottom plate 5. This leads to uniformize a force acting on the semiconductor wafer 4 and applies a uniform holding force to the semiconductor wafer 4. Therefore, the thin plate supporting convex strips 8 uniformize the force acting on the semiconductor wafer 4 by cooperating with the retainers 24 and apply a uniform holding force to the semiconductor wafer 4.

Two thin plate supporting convex strips 8 are provided with the bottom plate 5 formed in a rectangular shape at each side. Two adjacent thin plate supporting convex strips 8 have a wider space therebetween than the vacuum tweezers and the like of the transporting apparatus. As a result, the vacuum tweezers of the transporting apparatus pass through between the two adjacent thin plate supporting convex strips 8 to insert and remove the semiconductor wafer 4. In this case, eight thin plate supporting convex strips 8 are provided with the peripheral portion of the bottom plate 5. Alternatively, not more than seven or not less than nine thin plate supporting convex strips 8 may be provided within a range which does not obstruct insertion and removal of the vacuum tweezers. Further, the thin plate supporting convex strips 8 are provided near the peripheral portion of the bottom plate 5. Alternatively, the thin plate supporting convex strips 8 may be provided with an entire surface of the bottom plate 5 within a range which does not obstruct insertion and removal of the vacuum tweezers.

The locking pieces 9 come into contact with the peripheral portion of the semiconductor wafer 4 placed on the thin plate supporting convex strips 8 to prevent lateral slipping of the semiconductor wafer 4. The locking pieces 9 are provided with an end of the thin plate supporting convex strips 8. The locking pieces 9 are disposed at a circumferential position slightly larger than an outer diameter of the semiconductor wafer 4 placed on the thin plate supporting convex strips 8. Further, a contact surface of the locking pieces 9 is formed to curve along the peripheral portion of the semiconductor wafer 4. When the semiconductor wafer 4 slips laterally, the curved contact surface of the locking pieces 9 comes into contact with the peripheral portion of the semiconductor wafer 4 to prevent lateral slipping.

The bottom plate 5 has a center thicker than the peripheral portion. This is due to hold strength required to the bottom plate 5, so that a thickness in accordance with the required strength is set. Alternatively, the bottomplate 5 may be curvedly formed in a conical shape depending on a change of a thickness. For example, the bottom plate 5 is constituted so as to have the maximum thickness of 5 mm at the center, and the minimum thickness of 2 mm at the peripheral portion. Then, the thickness is gently changed to form the base plate 5. At this time, the bottom plate 5 is curvedly formed in a conical shape and the like depending on the change of a thickness, as necessary. This configuration eliminates a reinforcing rib on a back surface of the bottom plate 5 and depressions and projections to form a shape which is easily washed and excellently drained, while ensuring the required strength. That is, washing efficiency can be increased.

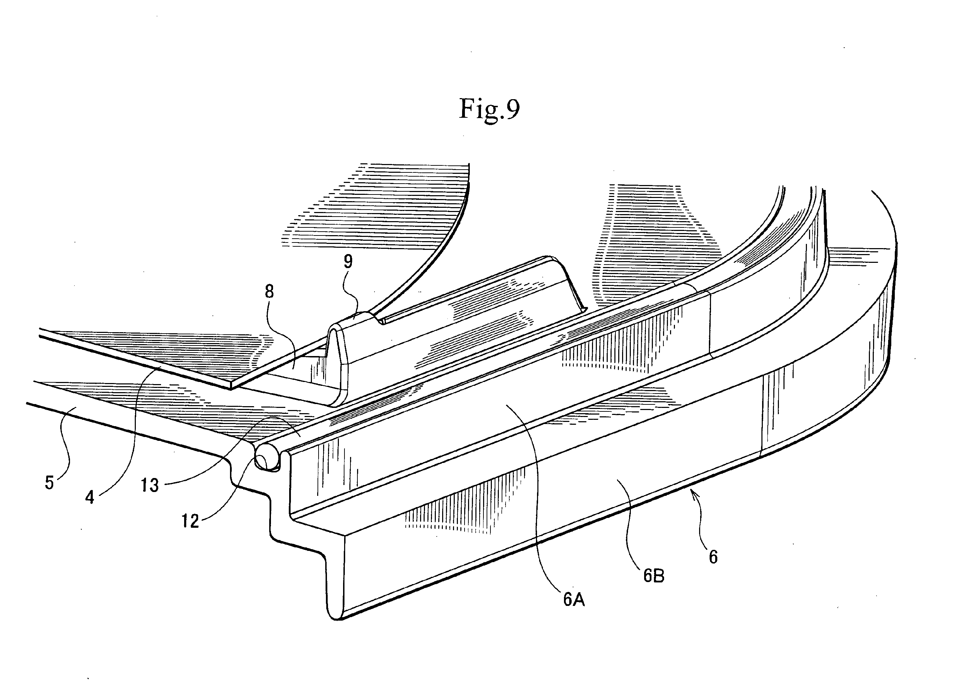

As shown in Fig. 9, the peripheral wall portion 6 is formed by extending downward from the peripheral portion of the bottom plate 5. The peripheral wall portion 6 is formed into two stages having a difference in level. A sealing groove 12 is disposed on a top surface of a difference in level of a first stage 6A over the entire circumferential portion. A sealing member 13 is attached into the sealing groove 12. The lid unit 3 covers the container body 2 so that a lower surface of difference in level in a first stage 22A of a peripheral wall portion 22 of the lid unit 3 comes into contact with the sealing member 13 and crushes the sealing member 13 to hermetically seal the inside of the single thin plate storage container 1. The first stage 6A of the peripheral wall portion 6 serves as a protruding fitting portion fitted in a recessed fitting portion (22B) of the lid unit 3 as described later.

A second stage 6B serves as the recessed fitting portion fitted in a protruding fitting portion (22A) of the lid unit 3 as described later. As shown in Figs. 4 to 7, a level difference of the second stage 6B includes hinge fitting portions 15 and hook fitting portions 16. The hinge fitting portions 15 are fitted in hinges 17, which will be described later, for rotatably supporting the lid unit 3 relative to the container body 2. The hinge fitting portions 15 are formed by a recess having the substantially identical size with fitting pieces 17A of the hinges 17 as described later. The fitting pieces 17A of the hinges 17 are fitted in the hinge fitting portions 15 to be tightly connected.

The hook fitting portions 16 are a recess for fitting hooks 18 as described later. The hooks 18 are fitted between the hook fitting portions 16 and hook fitting portions 29 of the lid unit 3 to fix the lid unit 3 to the container body 2 as described later. The hook fitting portions 16 are formed by a recess having the substantially identical size as the hooks 18. The hook fitting portions 16 of the container body 2 are aligned with the hook fitting portions 29 of the lid unit 3 so as to be formed as a recess having the substantially identical shape as the hooks 18. Both sidewalls of the hook fitting portions 16 are provided with cylindrical fitting projections 19. The fitting projections 19 are fitted in fitting recessed portions 18B of the hooks 18 to fix the container body 2 and the lid unit 3 as described later.

As shown in Figs . 10 and 11, each of the hinges 17 includes two fitting pieces 17A and 17B and a thinly thickness portion 17C formed between the fitting pieces 17A and 17B. The fitting pieces 17A and 17B are members for fitting in the hinge fitting portions 15 and 28 respectively to connect the container body 2 and the lid unit 3. The thinly thickness portion 17C is a member for eliminating a sliding portion, preventing generation of dust and the like, and rotatably supporting the lid unit 3.

The hinges 17 can be separated from and attached to the lid unit 3 and the container body 2 when the lid unit 3 has an open angle of 90 to 180 degrees relative to the container body 2. Specifically, when the lid unit 3 has an open angle of 90 to 180 degrees relative to the container body 2, the hinges 17 are detachably attached to the hinge fitting portions 15 and 28 of the container body 2 and the lid unit 3. When the hinges 17 are damaged, the damaged hinges 17 are replaced to new hinges 17. That is, when the hinges 17 are damaged, only the damaged hinges 17 can be replaced.

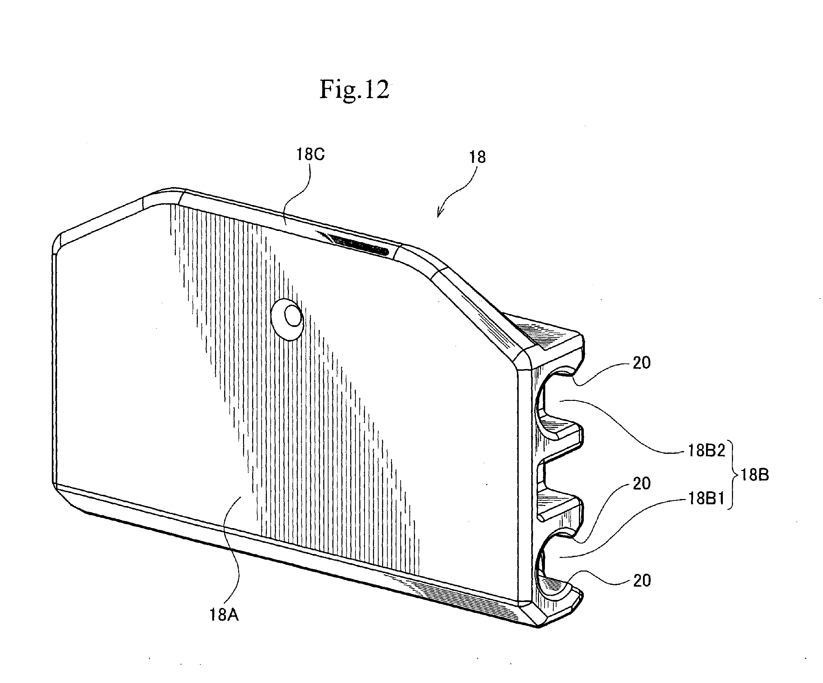

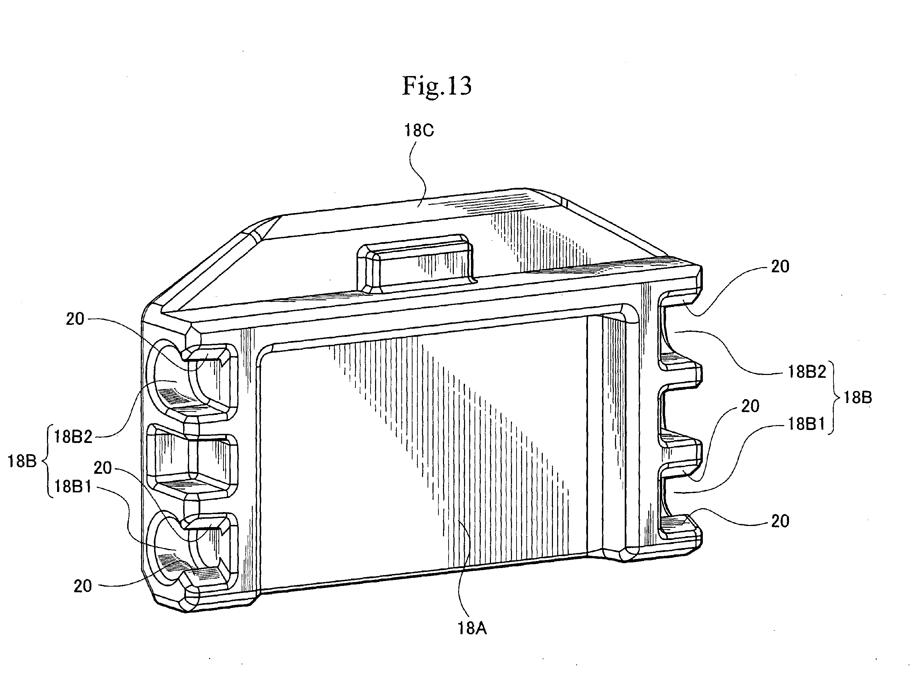

The hooks 18 are members for fitting into the hook fitting portions 16 of the container body 2 and the hook fitting portions 29 of the lid unit 3 to connect the container body 2 and the lid unit 3. As shown in Figs. 12 and 13, each of the hooks 18 includes a body portion 18A, fitting recessed portions 18B, and a gripping portion 18C. The body portions 18A are substantially formed into a rectangular plate shape and are fitted into a rectangular recess formed by the hook fitting portions 16 of the container body 2 and the hook fitting portions 29 of the lid unit 3.

The fitting recessed portions 18B are members for fitting into the fitting projections 19 and 30 of the hook fitting portions 16 and 29 to fix the lid unit 3 to the container body 2. Each of the fitting recessed portions 18B includes a rotating fitting recessed portion 18B1 and a connecting fitting recessed portion 18B2. The rotating fitting recessed portions 18B1 are members for roratably supporting the hooks 18 by fitting in the fitting projections 19 and 30. An inner surface shape of the rotating fitting recessed portions 18B1 is formed into an arcuate shape and is provided with wraparound portions 20 at both ends. As a result, the rotating fitting recessed portions 18B1 are hard to detach in a state where the rotating fitting recessed portions 18B1 are fitted in the fitting projections 19 and 30. Therefore, the hooks 18 are rotatably attached on the container body 2.

The connecting fitting recessed portions 18B2 are member for fitting into the fitting projections 19 and 30 when the lid unit 3 is fixed to the container body 2 and for removing the fitting projections 19 and 30 when the lid unit 3 is opened. The connecting fitting recessed portions 18B2 can be easily fitted and removed relative to the fitting projections 19 and 30 and are required to rigidly fix the lid unit 3 to the container body 2. Therefore, the wraparound portions 20 are only provided on the outside surface of the connecting fitting recessed portions 18B2 (upper side in Fig. 12). The inner side surface is formed into a flat plane and does not obstruct with insertion and removal of the fitting projections 19 and 30. As a result, when a force acts on a direction where the lid unit 3 tends to open relative to the container body 2, the wraparound portions 20 support the fitting projections 19 and 30 so as to cover the fitting projections 19 and 30 from the outside and prevent the hook 18 from removing. Further, when the hooks 18 are fitted and removed, the wraparound portion 20 provided only at one side provides merely a small obstacle relative to the fitting projections 19 and 30, so that the hooks 18 can be easily fitted and removed by light force.

The gripping portions 18C are portions for gripping by the fingers when the hooks 18 are fitted and removed. The gripping portions 18C are gripped by the fingers, the connecting fitting recessed portions 18B2 are fitted in the fitting projections 19 and 30, the lid unit 3 is fixed to the container body 2, the connecting fitting recessed portions 18B2 are removed from the fitting projections 19 and 30, and the lid unit 3 is opened.

Alternatively, the hooks 18 may be attached so that the gripping portions 18C face upward or downward.

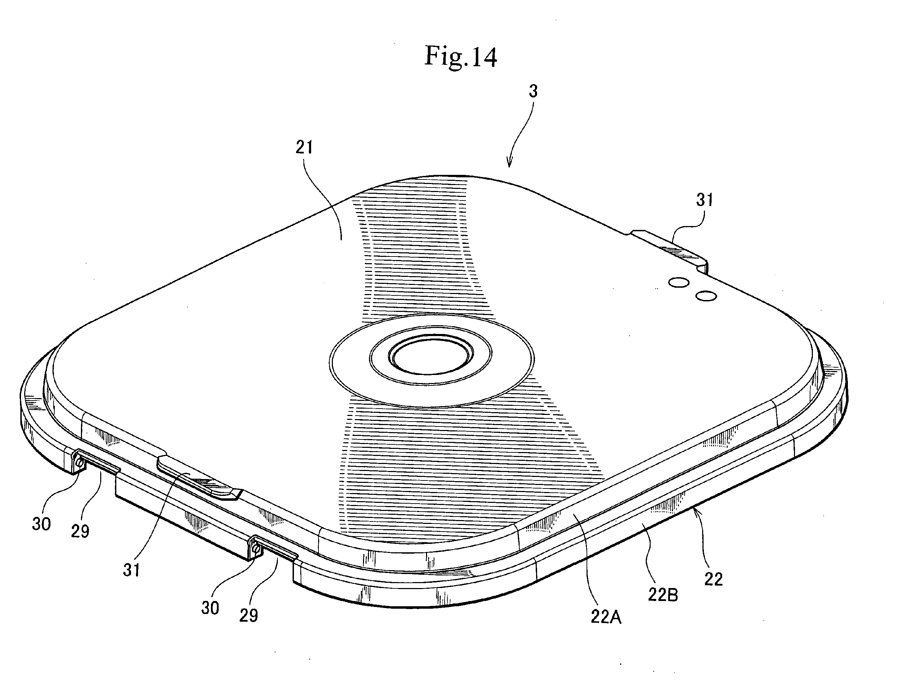

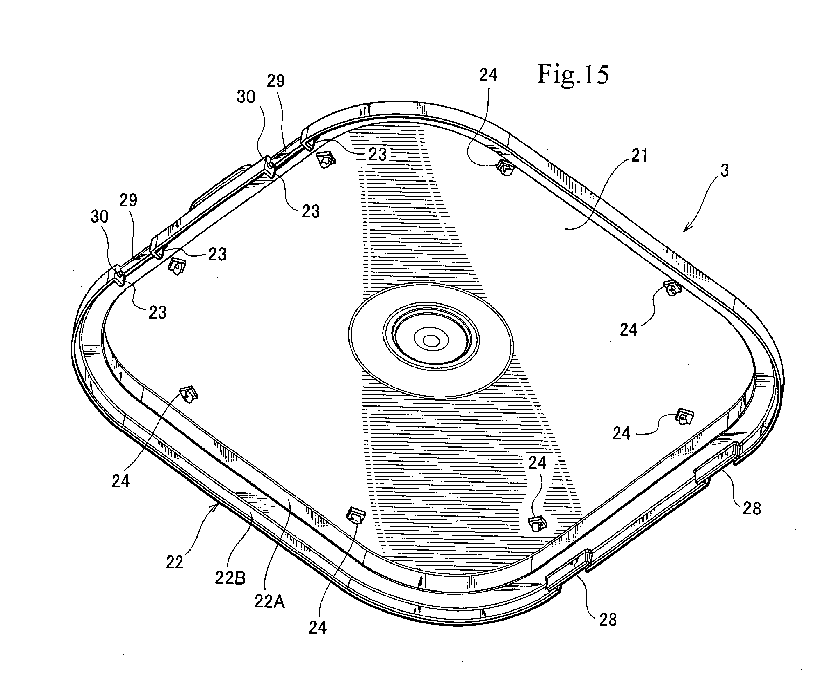

As shown in Figs. 14 and 15, the lid unit 3 is formed in substantially identical shape with the container body 2. As a result, when a plurality of single thin plate storage containers 1 are stacked on one another, the container body 2 of an upper single thin plate storage container 1 fits into the lid unit 3 of a lower single thin plate storage container 1 to allow a stable and compact stack. For example, in the single thin plate storage containers 1 according to an example embodiment, when two single thin plate storage containers 1, each having a height of 41 mm, are stacked on each other, the total height is 76 mm. On the other hand, in conventional single thin plate storage containers, when two single thin plate storage containers, each having a height of 49.5 mm, are stacked on each other, the total height is 90 mm. Therefore, an increase of the number of stack significantly decreases a stack height as compared with the conventional art.

Specifically, the lid unit 3 includes a top plate 21, the peripheral wall portion 22, and lid unit guides 23. The top plate 21 is a member for covering, from its upper side, the semiconductor wafer 4 placed on the bottom plate 5 of the container body 2. Similar to the bottom plate 5, the top plate 21 has a center thicker than the peripheral portion. This is because strength required to the top plate 21 is maintained. Therefore, a thickness is set depending on the required strength. This configuration eliminates a reinforcing rib on a back surface of the top plate 21, depressions and projections, and improves washing efficiency.

Retainer fitting portions (not shown) in which the retainers 24 fit are provided on an inner side surface of the top plate 21 of the lid unit 3 as described later. Eight retainer fitting portions are provided on the inner side surface of the top plate 21. The respective retainer fitting portions are provided on the inner side surface of the top plate 21 by facing toward the peripheral portion of the semiconductor wafer 4 placed on the bottom plate 5 of the container body 2.

The peripheral wall portion 22 is formed by extending downward from the periphery of the top plate 21. Similar to the peripheral wall portion 6 of the container body 2, the peripheral wall portion 22 is formed into two stages having a difference in level. Thus, in a state where the lid unit 3 is covered on the container body 2, a space for housing the semiconductor wafer 4 is formed by the bottom plate 5 of the container body 2 and the top plate 21 and the peripheral wall portion 22 of the lid unit 3. The first stage 22A is formed as a protruding fitting portion fitting in the recessed fitting portion (6B) of the container body 2 from the lower side. The second stage 22B is formed as the recessed fitting portion fitting in a protruding fitting portion (6A) of the container body 2 from the upper side.

On the lower surface of the first stage 22A of a difference in level of the peripheral wall portion 22, a contact surface is provided over the entire circumferential portion. The contact surface comes into contact with the sealing member 13 of the container body 2 side to hermetically seal the inside of the single thin plate storage container 1. An outer peripheral surface of the second stage 22B is formed to be flush with an outer peripheral surface of the second step 6B having a difference in level formed in the container body 2. That is, the portions to be matched are formed to be flush while the container body 2 and the lid unit 3 are closed (see Fig. 1) . This is because a sealing tape can be attached to the matching portion to be flush without providing the sealing member 13.

The lid unit guides 23 are guides for guiding the lid unit 3 so as to prevent deviation of the lid unit 3 and the container body 2 when the lid unit 3 is covered on the container body 2. The lid unit guides 23 are formed by projecting from both sides to an inner side of the hook fitting portions 29 of the lid unit 3. When the lid unit 3 covers the container body 2, the lid unit guides 23 are formed to be opposed to the peripheral wall portion 6 of the container body 2 while a small space is provided. Consequently, when the lid unit 3 rotates around the hinges 17, covers the container body 2, and makes a deviation, the lid unit guides 23 guide the lid unit 3. Since the lid unit 3 is supported by two hinges 17, the lid unit 3 is normally not deviated. However, when the lid unit 3 is deviated from the container body 2 by some reason, the lid unit guides 23 come into contact with the peripheral wall portion 6 of the container body 2 to guide the lid unit 3. Alternatively, the lid unit guides 23 can be provided with the container body 2 side, or can be provided with both sides of the container body 2 and the lid unit 3.

The hinge fitting portions 28 of the lid unit 3 are provided at a position opposite to the hinge fitting portions 15 of the container body 2. The hinge fitting portions 28 are fitted in the hinges 17 for rotatably supporting the lid unit 3 to the container body 2. The hinge fitting portions 28 are formed by a recessed portion having the substantially identical size as the fitting pieces 17A of the hinges 17 in the same manner as the hinge fitting portions 15. The fitting pieces 17A of the hinges 17 are fitted in and connected tightly with the hinge fitting portions 28.

The hinge fitting portions 29 of the lid unit 3 are provided at a position opposite to the hinge fitting portions 16 of the container body 2. The hinge fitting portions 29 are mirror-symmetrically formed in a substantially identical structure to the hinge fitting portions 16 of the container body 2. Matching the hinge fitting portions 29 and the hinge fitting portions 16 of the container body 2 forms a recessed portion having substantially identical size and shape as the hooks 18.

Both sidewalls of the hook fitting portions 29 are provided with the cylindrical fitting projections 30 in the same manner as the fitting projections 19 of the hinge fitting portions 16 of the container body 2. The fitting projections 30 are fitted in the fitting recessed portions 18B of the hooks 18 to fix the container body 2 and the lid unit 3 as described later.

Locking flanges 31 for carrying the single thin plate storage container 1 are disposed on a periphery of the upper side surface of the top plate 21. The locking flanges 31 are formed by a plate piece horizontally extending from the top plate 21. The two locking flanges 31 are provided in a direction opposed to a position of the hinge fitting portions 28 and the hook fitting portions 29. The position and shape of the locking flanges 31 are properly set according to the shape of an arm of a transporting apparatus (not shown).

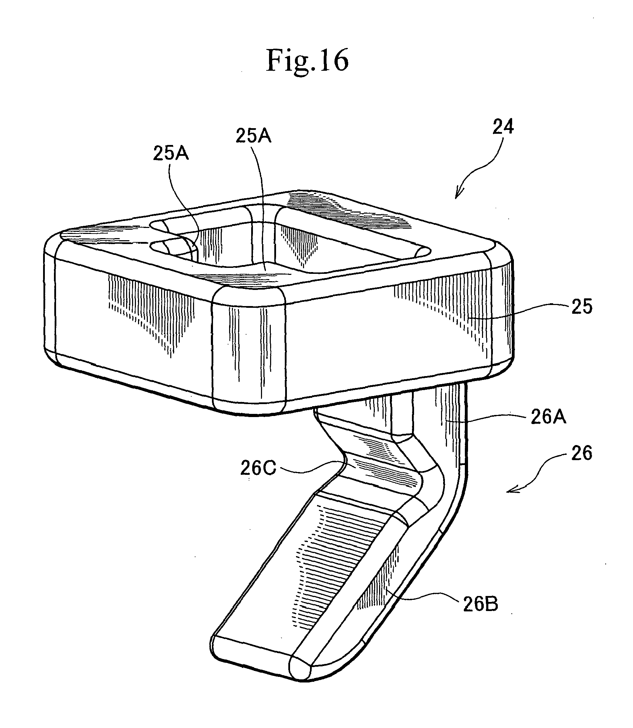

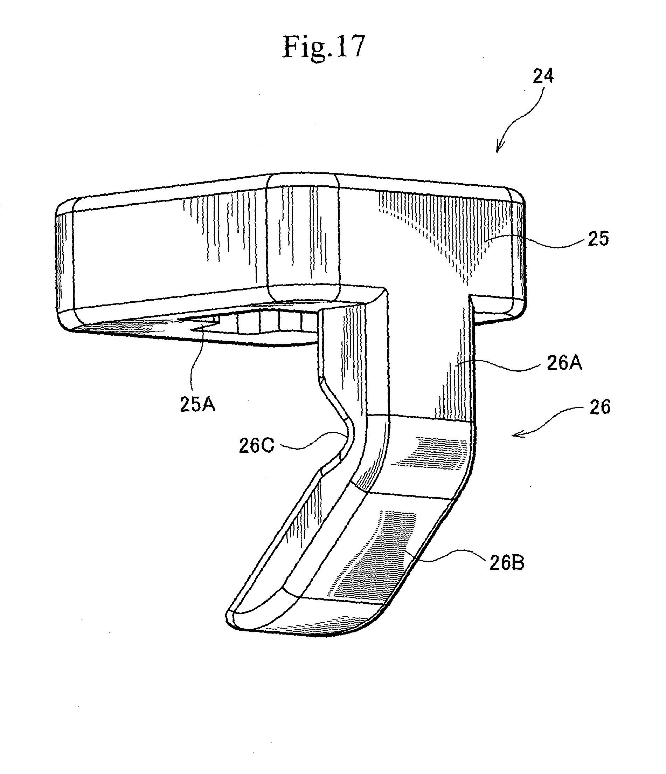

The retainers 24 are members for supporting the peripheral portion of the semiconductor wafer 4 placed on the bottom plate 5 of the container body 2. The retainers 24 are made of elastic synthetic resin. As shown in Figs. 16 and 17, each of the retainers 24 includes a base portion 25 and a flexible piece 26. The base portion 25 is a portion for fitting in the retainer fitting portion of the top plate 21onthelidunit3. The base portion 25, substantially formed in a rectangular annular shape, whose two right angles has projections 25A to match the shape of the retainer fitting portion. The base portion 25 is fit in the retainer fitting portion in the form of a protrusion to securely fix the retainers 24 to the retainer fitting portion. The retainer fitting portion is formed in a square pole provided on the lid unit 3 or a protrusion similar shape of a square pole. The protrusion is fitted in the rectangular annular shaped base portion 25, so that the retainers 24 can be attached on the lid unit 3.

The flexible pieces 26 contact and support the semiconductor wafer 4. The flexible pieces 26 are formed by extending from the base portion 25 to the semiconductor wafer 4. Each of the flexible pieces 26 includes a base end piece 26A, a tip end piece 26B, and the thinly thickness portion 26C. The flexible pieces 26 are made of elastic synthetic resin, so chat the base end piece 26A and the tip end piece 26B are also deflected. Specifically, the thinly thickness portion 26C is well deflected. The base end piece 26A and the tip end piece 26B are deflected centering the thinly thickness portion 26C to elastically support the semiconductor wafer 4. Further, the tip end piece 26B is formed by inclining with respect to the base end piece 26A. When the tip end piece 26B comes into contact with the peripheral portion of the semiconductor wafer 4, the tip end piece 26B elastically presses the semiconductor wafer 4 radially inward and downward.

The single thin plate storage container 1 having the above configuration is used in the following way.

When the semiconductor wafer 4 is housed, the single thin plate storage container 1 is disposed on a mounting base (not shown) of a semiconductor wafer transporting apparatus. The hooks 18 are then removed and the lid unit 3 is opened. In this state, the vacuum tweezers of the transporting apparatus support the semiconductor wafer 4 and move the semiconductor wafer 4 to a section immediately above the bottom plate 5. Subsequently, the vacuum tweezers are lowered and the semiconductor wafer 4 is placed on the thin plate supporting convex strips 8 of the bottom plate 5. In this state, a space wider than the vacuum tweezers is secured between the semiconductor wafer 4 and the bottom plate 5. Therefore, the vacuum tweezers are withdrawn without contact with the semiconductor wafer 4. Then, the lid unit is closed and the hooks 18 are locked.

At this time, in the single thin plate storage container 1, the retainers 24 of the inner side surface of the lid unit 3 come into contact with the peripheral portion of the semiconductor wafer 4 and support the semiconductor wafer 4 from the peripheral portion. Consequently, the top surface of the semiconductor wafer 4 is supported by the retainers 24 so as to be pressed and supported radially inward and downward. Further, the lower side of the semiconductor wafer 4 is supported by the thin plate supporting convex strips 8. As a result, the semiconductor wafer 4 is pressed toward center so as to be sandwiched at its top and bottom. Therefore, the semiconductor wafer 4, formed into a thin and wide shape, can be securely supported.

At this time, the inside of the single thin plate storage container 1 is sealed by the sealing member 13. Alternatively, without providing the sealing member 13, the matching portion to be flush can be sealed by winding a tape in a state where the container body 2 and the lid unit 3 are closed each other.

In this state, the locking flanges 31 are connected by an arm portion of the transporting apparatus, and the arm lifts and transports the single thin plate storage container 1.

When the semiconductor wafer 4 is removed from the single thin plate storage container 1, the hooks 18 are released and the lid unit 3 is opened. The vacuum tweezers are inserted into the space between the semiconductor wafer 4 and the bottom plate 5. Then, the vacuum tweezers are raised to lift and transport the semiconductor wafer 4.

When the single thin plate storage container 1 is washed, the hooks 18 are released from the container body 2 and the lid unit 3. The hinges 17 are taken out from the container body 2 and the lid unit 3. Then, the retainers 24 are also taken out from the retainer fitting portion. The seal member 13 is also taken out from the sealing groove 12.

After these components are individually washed and dried, the hinges 17 and hooks 18 and the like are attached.

As described above, the single thin plate storage container 1 exhibits the following advantages.
(1) The bottom plate 5 of the container body 2 is formed by protruding up to a position higher than the peripheral wall portion 6. Therefore, means for supporting the semiconductor wafer 4 such as vacuum tweezers can be inserted from lateral direction of the container body 2 into the lower side of the semiconductor wafer 4. As a result, the semiconductor wafer 4 housed in the single thin plate storage container 1 can easily be inserted or removed.
(2) The bottom plate 5 of the container body 2 is provided with the thin plate supporting convex strips 8 for supporting the semiconductor wafer 4 in a state where a space is provided between the bottom plate 5 and the semiconductor wafer 4. Therefore, the vacuum tweezers and the like can be securely inserted into the lower side of the semiconductor wafer 4.
(3) The thin plate supporting convex strips 8 are formed so that the container body 2 is inclined low in the center side and high in the peripheral side. Therefore, the thin plate supporting convex strips can only come into contact with the peripheral portion of a lower surface of the semiconductor wafer 4 to support the semiconductor wafer 4.
(4) The thin plate supporting convex strips 8 are extendedly formed in a radial shape. Therefore, the thin plate supporting convex strips 8 can stably support the semiconductor wafer 4 from the peripheral portion.
(5) The bottom plate 5 of the container body 2 is provided with the locking pieces 9. Therefore, the locking pieces 9 come into contact with the peripheral portion of the semiconductor wafer 4 placed on the thin plate supporting convex strips 8 to prevent lateral slipping of the semiconductor wafer 4. As a result, the deviation of the semiconductor wafer 4 can be prevented during transportation of the single thin plate storage container 1.
(6) The plurality of locking pieces 9 are disposed on a circumferential position slightly larger than an outer diameter of the semiconductor wafer 4 placed on the thin plate supporting convex strips 8. Therefore, when the semiconductor wafer 4 is placed so as to match the center of the container body 2, the semiconductor wafer 4 and the locking pieces 9 do not come into contact with each other. When the semiconductor wafer 4 is deviated, the locking pieces 9 can come into contact with the peripheral portion of the semiconductor wafer 4 to prevent the deviation of the semiconductor wafer 4.
(7) The contact surface of the locking pieces 9 is formed to curve along the peripheral portion of the semiconductor wafer 4. Therefore, even when the semiconductor wafer 4 is abruptly deviated and the locking pieces 9 come into contact with the semiconductor wafer 4 violently, the curved contact surface of the locking pieces 9 comes into contact with the peripheral portion of the semiconductor wafer 4 in a wide range to securely support the semiconductor wafer 4.
(8) The inner side surface of the top plate 21 of the lid unit 3 is provided with the plurality of retainers 24 for supporting the peripheral portion of the semiconductor wafer 4 placed on the bottom plate 5 of the container body 2. Therefore, while the lid unit 3 is covered on the container body 2, the semiconductor wafer 4 placed on the thin plate supporting convex strips 8 can be supported from the peripheral portion to prevent the lateral slipping.
(9) The retainers 24 are formed of an elastic member and the inner side surface of the top plate 21 of the lid unit 3 is provided with the retainer fitting portion on which the retainers 24 are attached. Therefore, the retainers 24 are attached on the retainer fitting portion at the time of using the single thin plate storage container 1 and the retainers 24 are detached from the retainer fitting portion at the time of washing, so that washing efficiency can be improved.
(10) The retainers 24 include the base portion 25 fitted in the retainer fitting portion and the flexible piece 26 formed by extending from the base portion 25 to the semiconductor wafer 4. The flexible piece 26 comes into contact with the peripheral portion of the semiconductor wafer 4 and elastically presses the semiconductor wafer 4 radially inward and downward. Therefore, the semiconductor wafer 4 placed on the thin plate supporting convex strips 8 of the container body 2 can be elastically, stably pressed and supported by the flexible piece 26 radially inward and downward.
(11) The thin plate supporting convex strips 8 are formed to come into point, line, or surface contact with the peripheral portion of the semiconductor wafer 4 by a minimum area. Therefore, the thin plate supporting convex strips 8 come into excessive contact with the semiconductor wafer 4 to prevent the lower surface of the semiconductor wafer 4 from being damaged.
(12) The sectional shape of the thin plate supporting convex strips 8 is formed in such a manner as to be narrower toward the contact portion with the semiconductor wafer 4 . Therefore, the thin plate supporting convex strips 8 can come into point, line, or surface contact with the peripheral portion of the semiconductor wafer 4 by a minimum area. As a result, the thin plate supporting convex strips 8 come into excessive contact with the semiconductor wafer 4 to prevent the lower surface of the semiconductor wafer 4 from being damaged.
(13) The container body 2 and the lid unit 3 are connected by the hinges 17 and fixed by the hooks 18. Therefore, the lid unit 3 can be easily fixed to the container body 2 and easily opened.
(14) The sealing member 13, provided between the container body 2 and the lid unit 3, hermetically seals the inside of the single thin plate storage container 1 in a state where the container body 2 and the lid unit 3 are connected by the hinges 17 and fixed by the hooks 18. Therefore, the lid unit 3 is only covered and fixed on the container body 2 while the semiconductor wafer 4 are housed, thereby easily and securely sealing the semiconductor wafer 4 hermetically.
(15) The lid unit 3 connected to the container body 2 by the hinges 17 is separated from the container body 2 at the open angle of 90 to 180 degrees. Therefore, in the case of washing operation, the lid unit 3 can be easily removed to be washed. This improves washing operation.
(16) The container body 2 and the lid unit 3 are formed in a substantially identical shape. With the lid unit 3 closed, the container body 2 of the upper single thin plate storage container 1 fits into the lid unit 3 of the lower single thin plate storage container 1, so that the plurality of single thin plate storage containers 1 can be stacked in several stages. Therefore,the plurality ofsinglethin platestorage containers 1 can be easily and stably stacked. Further, the container body 2 of the upper single thin plate storage container 1 fits into the lid unit 3 of the lower single thin plate storage container 1, so that the plurality of single thin plate storage containers 1 are stacked in several stages. Therefore, the stack height is not so high that the single thin plate storage containers 1 can compactly stacked.
(17) The container body 2 and the lid unit 3 are formed in a substantially identical shape, so that the matching portion is formed to be flush while the container body 2 and the lid unit 3 are closed each other. Therefore, the inside of the single thin plate storage container 1 can be sealed by winding a tape around the matching portion.
(18) One of or both the container body 2 and lid unit 3 are formed of an antistatic high polymer material. Therefore, adsorption of dust and the like can prevent contamination of the semiconductor wafer 4. Further, at least the lid unit 3 is formed of transparent high polymer material. Therefore, it is possible to visually determine the inside condition of the single thin plate storage container 1 in which the semiconductor wafer 4 is housed.
(19) The lid unit 3 is provided with the lid unit guides 23 opposed to the container body 2. Therefore, the lid unit guides 23 guides the lid unit 3 so as to prevent deviation of the lid unit 3 and the container body 2 when the lid unit 3 is covered on the container body 2. As a result, the lid unit 3 can be securely and accurately closed. Accordingly, the retainers 24 of the lid unit 3 can securely come into contact with the peripheral portion of the semiconductor wafer 4 of the container body 2 and support the semiconductor wafer 4.
(20) The peripheral portion of the lid unit 3 is provided with the locking flanges 31 for carrying the single thin plate storage container 1. Therefore, when the single thin plate storage container 1 is transported, the locking flanges 31 are gripped by the arm portion of the transporting apparatus to be easily transported.
(21) One of or both the bottom plate 5 of the container body 2 and the top plate 21 of the lid unit 3 have a center thicker than the peripheral portion. This eliminates the need for providing the reinforcing rib, thus eliminating depressions and projections. As a result, the container body 2 and the lid unit 3 are easily washed and excellently drained, so that washing efficiency is improved.

### [Modifications]

Although the thin plate supporting convex strips 8 are arrange in a radial shape in the foregoing embodiment, a plurality of thin plate supporting convex strips 8, arranged in parallel as one set, are formed by extending radially. Any structure may be employed as long as the thin plate supporting convex strips 8 are arranged so as not to obstruct insertion of the vacuum tweezers. In this case, the identical operations and advantages to the foregoing can be provided as well.

Further, two thin plate supporting convex strips 8, formed as one set, are provided on each one of the four sides (peripheral portion) of the rectangular bottom plate 5. However, the thin plate supporting convex strips 8 can be provided with the entire surface of the bottom plate 5 from the center to the peripheral portion within a range which does not obstruct insertion of the vacuum tweezers. In this case, the identical operations and advantages to the foregoing can be provided as well.

## Claims

1. A single thin plate storage container, comprising:
a container body which houses a single thin plate therein; and
a lid unit attached to the container body,
wherein the container body includes: a bottom plate on which the thin plate is placed; and a peripheral wall portion formed around the bottom plate, the bottom plate formed by protruding up to a position higher than the peripheral wall portion, and
the lid unit includes: a top plate which covers, from a upper side, the thin plate placed on the bottom plate of the container body; and a peripheral wall portion formed around the top plate, the peripheral wall portion forming a space in which houses the thin plate.

2. The single thin plate storage container according to claim 1, further comprising a plurality of thin plate supporting convex strips, provided on the bottom plate of the container body, for supporting the thin plate in a state where a space is provided between the thin plate and the bottom plate.

3. The single thin plate storage container according to claim 2, wherein the thin plate supporting convex strips are formed so that the container body is inclined low in a center side and high in a peripheral side.

4. The single thin plate storage container according to claim 2, wherein the thin plate supporting convex strips are formed by extending radially.

5. The single thin plate storage container according to claim 2, wherein the plurality of thin plate supporting convex strips, arranged in parallel as one set, are formed by extending radially.

6. The single thin plate storage container according to claim 2, wherein the container body includes locking pieces which come into contact with a peripheral portion of the thin plate placed on the thin plate supporting convex strips to prevent lateral slipping of the thin plate.

7. The single thin plate storage container according to claim 6, wherein the locking pieces are disposed on a circumferential position slightly larger than an outer diameter of the thin plate placed on the thin plate supporting convex strips.

8. The single thin plate storage container according to claim 6, wherein a contact surface of the locking pieces is curved along the peripheral portion of the thin plate.

9. The single thin plate storage container according to claim 1, wherein an inner side surface of the top plate of the lid unit is provided with a plurality of retainers which support a peripheral portion of the thin plate placed on the bottom plate.

10. The single thin plate storage container according to claim 9, wherein the retainers are formed of an elastic member and the inner side surface of the top plate of the lid unit includes a retainer fitting portion on which the retainers are attached.

11. The single thin plate storage container according to claim 10, wherein the retainers include: a base portion fitted in the retainer fitting portion; and a flexible piece formed by extending from the base portion to the thin plate, the flexible piece coming into contact with the peripheral portion of the thin plate to elastically press the thin plate radially inward and downward.

12. The single thin plate storage container according to claim 2, wherein the thin plate supporting convex strips come into point, line, or surface contact with the peripheral portion of the thin plate by a minimum area.

13. The single thin plate storage container according to claim 2, wherein a sectional shape of the thin plate supporting convex strips is formed to be narrower toward a contact portion with the thin plate.

14. The single thin plate storage container according to claim 1, wherein the container body and the lid unit are connected by a hinge, and fixed by a hook.

15. The single thin plate storage container according to claim 14, further comprising a sealing member provided between the container body and the lid unit, the sealing member hermetically sealing an inside in a state where the container body and the lid unit are connected by the hinge and fixed by the hook.

16. The single thin plate storage container according to claim 14, wherein the lid unit connected to the container body by the hinge is separated from the container body at open angles of 90 to 180 degrees.

17. The single thin plate storage container according to claim 1, wherein the container body and the lid unit are formed in substantially an identical shape, and the container body of an upper single thin plate storage container fits into the lid unit while the lid unit is closed, so that the single thin plate storage container is stackable in several stages.

18. The single thin plate storage container according to claim 1, wherein the container body and the lid unit, formed in substantially an identical shape, whose matching portion is flush while the container body and the lid unit are closed each other.

19. The single thin plate storage container according to claim 1, further comprising a lid unit guide provided to one of or both the lid unit and the container body so as to oppose a counter part, the lid unit guide guiding the lid unit and the container body so as to prevent deviation when the lid unit is covered on the container body.

20. The single thin plate storage container according to claim 1, wherein one of or both the container body and lid unit are formed of antistatic high polymer material, and at least the lid unit is formed of transparent high polymer material.

21. The single thin plate storage container according to claim 1, further comprising a locking flange for carrying provided on a peripheral portion of the lid unit.

22. The single thin plate storage container according to claim 1, wherein one of or both the bottom plate of the container body and the top plate of the lid unit have a center thicker than the peripheral portion.
